# EUROPÄISCHE PATENTSCHRIFT

(11) **EP 0 654 799 B1**
(45) Veröffentlichungstag und Bekanntmachung des Hinweises auf die Patenterteilung: **18.09.1996**
(21) Anmeldenummer: 94105581.6
(22) Anmeldetag: 11.04.1994
(51) Int. Cl.: H01C 1/14, H01C 7/00, H01C 1/144

(54) **Widerstand in SMD-Bauweise und Verfahren zu seiner Herstellung**
Chip form of surface mounted electrical resistance and its manufacturing method
Résistance électrique sous forme de puce à montage de surface et son procédé de fabrication

(30) Priorität: 19.11.1993 DE 4339551
(43) Veröffentlichungstag der Anmeldung: 24.05.1995
(73) Patentinhaber: Isabellenhütte Heusler GmbH KG, D-35683 Dillenburg (DE)
(72) Erfinder: Hetzler, Ullrich, Dr., D-35683 Dillenburg-Oberscheld (DE)
(74) Vertreter: Heusler, Wolfgang, Dipl.-Ing.

(56) Entgegenhaltungen:
- EP-A- 0 484 756
- EP-A- 0 509 582
- DE-A- 3 705 279
- DE-A- 4 143 217
- US-A- 5 111 179

## Beschreibung

Die Erfindung betrifft einen Widerstand in SMD-Bauweise gemäß dem Oberbegriff des Anspruchs 1 und ein Verfahren zu seiner Herstellung.

Bei der industriellen Fertigung von Flachbaugruppen findet in zunehmendem Maße die SMD-Technik Anwendung (SMD ist die Abkürzung für Surface Mounted Devices). Bei dieser Oberflächenmontagetechnik werden die Bauelemente nicht mit drahtartigen Anschlußbeinchen an die Leiterplatte angeschlossen, sondern mit flachen Kontaktelementen aufgelötet. Das Auflöten kann durch eine Reflow-Methode (Wiederaufschmelzlöten) oder durch andere bekannte Methoden wie z.B. Schwallöten unter Verwendung eines Zinnbades erfolgen. Ein wesentlicher Vorteil der Oberflächenmontage ist die Verkleinerung und bessere Ausnutzung des benötigten Platzes auf der Leiterplatte. Dieser Vorteil ist umso größer, je kleiner die Bauelemente sind.

Bei typischen SMD-Schichtwiderständen, die auch als Chip-Widerstände bezeichnet werden, ist die Widerstandsschicht über am Rand eines Substrates befindliche leitende Verbindungsschichten mit zwei den Substratrand umgreifenden lötbaren Außenkappen od. dgl. verbunden, die als Kontaktelemente auf die Leiterplatte gelötet werden (DE 37 05 279 A1). Zur Herstellung dieser Widerstände können auf einer gemeinsamen Substratplatte aus isolierendem Werkstoff wie Aluminiumoxid jeweils eine Anzahl von Schichtwiderstandselementen zwischen zueinander parallelen schlitzförmigen Aussparungen in Dickfilmtechnik erzeugt und danach in Dünnfilmtechnik zur Bildung der Außenkappen von den Rändern der Schichtwiderstandselemente durch die schlitzförmigen Aussparungen hindurch auf die Substratrückseite verlaufende Elektrodensschichten aufgebracht werden, worauf das Substrat quer zu den Schlitzen zerteilt und dadurch die erzeugten Widerstände vereinzelt werden. Stattdessen kann auch eine Widerstandsschicht in Dünnfilmtechnik auf ein streifenförmiges isolierendes Substrat aufgebracht werden, das an seinen Rändern zur Bildung der Außenkappen mit einem Elektrodenfilm versehen wird, worauf die Widerstandsschicht zur Bildung eines vorbestimmten Musters von Widerstandselementen geätzt und schließlich das Substrat zum Vereinzeln der Widerstände zertrennt wird. Die Widerstände lassen sich nach diesem Verfahren nicht problemlos in großen Stückzahlen herstellen und eignen sich vor allem nicht für hohe Ströme und große Verlustleistungen, insbesondere wegen der relativ schlechten Wärmeableitung durch das Substrat aufgrund dessen Isoliermaterials und seiner aus Festigkeitsgründen erforderlichen Dicke.

Es sind auch bereits u.a. für Meßzwecke geeignete Präzisionswiderstände in SMD-Bauweise mit relativ geringen Widerstandswerten bis in den Milliohmbereich bekannt, deren eigentliches Widerstandselement oder Widerstandsbahn durch Fotoätzen aus einer dünnen Folie beispielsweise aus einer CuNi-Legierung gebildet wird (EP 0 484 756 A2). Die Widerstandsmetallfolie dieser bekannten Bauelemente ist auf ihrer einen Seite mit Anschlußflecken aus Lötmetall versehen, mit denen der Widerstand auf Anschlußleiter einer Leiterplatte aufgelötet wird, wahrend sie auf ihrer anderen Seite an eine wärmeleitende Metallplatte beispielsweise aus Aluminium angeklebt ist, die aber nicht mit der Leiterplatte verbunden ist.

Der Erfindung liegt die Aufgabe zugrunde, mit geringem Aufwand die Herstellung einer großen Stückzahl von SMD-Widerständen, vorzugsweise niederohmigen (≤ 1Ω ) Präzisionswiderständen für Meßzwecke od. dgl. zu ermöglichen, die bei minimalen Abmessungen hoch belastbar sein sollen.

Diese Aufgabe wird durch den Widerstand bzw. das Verfahren gelöst, wie sie in den Patentansprüchen beschrieben sind.

Bei den erfindungsgemäß hergestellten Widerständen sorgen die großflächigen plattenartigen Kontaktelemente, die typisch aus Kupfer bestehen können und neben der Funktion der effektiven elektrischen Stromzuführung zugleich auch als Trägerplatte (also als Substrat) und als wärmeleitender Kühlkörper dienen, für optimale Wärmeübertragung von der Widerstandsbahn in die Leiterplatte. Dadurch werden Widerstände mit extrem niedrigem thermischem Innenwiderstand ermöglicht, der in der Größenordnung von 15 K/W liegen kann (während er bei vergleichbaren handelsüblichen Bauformen bis zu 170 K/W beträgt). Aufgrund der guten Wärmeableitung ist der Widerstand hoch belastbar, bei typischen Ausführungsformer bis 2 W und für Ströme bis 30 A. Auch eine hohe Pulsbelastbarkeit wird erreicht. Typische Widerstandswerte können zwischen 1 und 1 m liegen. Die Dicke des Widerstands kann weniger als 1,5 mm betragen.

Ferner zeichnet sich der Widerstand aufgrund seiner Kontaktelemente durch extrem niedrige Zuleitungswiderstände aus. Infolgedessen hat der Widerstand den bei gegebenem Widerstandsmaterial geringstmöglichen Temperaturkoeffizienten (TK), und in vielen Fällen ist eine Vierleiterausführung überflüssig, die sonst bei Meßwiderständen zur Vermeidung des Einflusses der Kontaktstellen auf den Gesamtwiderstandswert und den TK notwendig ist, sich bei sehr kleinen Bauelementen aber schwer realisieren läßt.

Darüberhinaus erfüllt der Widerstand verschiedene sonstige in der Praxis wichtige Voraussetzungen. Insbesondere ist seine Herstellung unter Anwendung an sich bewährter und zuverlässiger Verfahrenstechniken in großen Stückzahlen mit geringem Aufwand und dennoch mit höchster Genauigkeit möglich. Beispielsweise lassen sich auf einem Kupferblech mindestens 2000 Präzisionswiderstände gemeinsam, also praktisch gleichzeitig herstellen. Von Vorteil ist hierbei die mechanische Festigkeit des als Träger dienenden Metallbleches im Vergleich mit den Isoliermaterialsubstraten konventioneller SMD-Widerstände. Hierbei werden weder kostspielige noch besonders umweltbelastende Materialien benötigt. Bei Verwendung von Widerstandsfolien aus ebenfalls bewährten Legierungen vorzugsweise auf CuNi-Basis können Widerstände mit kleinem TK und geringen Toleranzen erzeugt werden. Insbesondere bei zweckmäßiger geometrischer Anordnung (Layout) der Widerstandsbahnen ist auch der an sich übliche Abgleich der Widerstandswerte mit einem rechnergesteuerten Fräser besonders einfach und genau durchführbar.

Die erfindungsgemäß hergestellten Widerstände sind beispielsweise mit konventionellen SMD-Bauelementen kompatibel und eignen sich deshalb bei Anordnung in den üblichen Standardgurten für die bekannten Vorrichtungen zur automatischen Bestückung von Leiterplatten. Nach der Montage sind (im Gegensatz zu den Widerstandsanordnungen nach der oben erwähnten EP 0 484 756 A2) die um die Außenkanten der großen Lötflächen der Kontaktelemente verlaufenden Lötstellen von außen sichtbar und entsprechend gut optisch kontrollierbar.

An einem bevorzugten Ausführungsbeispiel wird die Erfindung näher erläutert. In der Zeichnung zeigen:
- Fig. 1: einen erfindungsgemäß hergestellten Widerstand in stark vergrößerter Draufsicht auf die Widerstandsbahn;
- Fig. 2: eine Seitenansicht des Widerstands nach Fig. 1;
- Fig. 3: die Unterseite des Widerstands nach Fig. 1 und 2;
- Fig. 4: Darstellungen zur Erläutertung der Herstellung des Widerstands in aufeinanderfolgenden Verfahrensschritten; und
- Fig. 5: Anschlußleiter einer Leiterplatte, auf die der Widerstand aufgelötet werden kann.

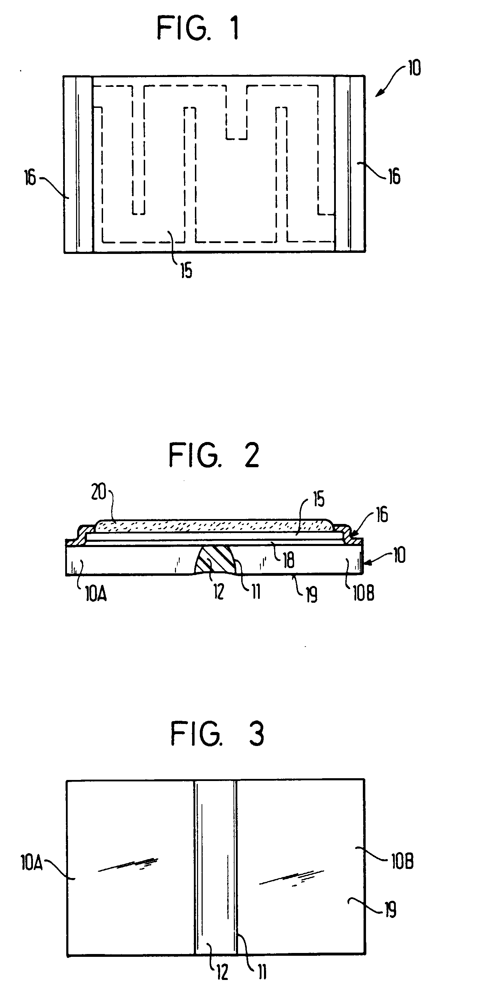

Wie in Fig. 1 erkennbar ist, trägt eine rechteckförmige Trägerplatte 10 eine mäanderförmige Widerstandsbahn 15, die sich unter einer Schutzlackschicht (20 in Fig. 2) befindet und deshalb gestrichelt dargestellt ist. An zwei entgegengesetzten Rändern der Trägerplatte 10 ist die Widerstandsbahn 15 an ihren jeweiligen Enden durch je eine streifenförmige Metallschicht 16 elektrisch mit der Trägerplatte verbunden.

In Fig. 2 ist der innere Aufbau des Widerstands erkennbar. Darstellungsgemäß besteht die Trägerplatte 10 aus zwei Plattenelementen 10A und 10B, die durch einen parallel zu den streifenförmigen Metallschichten 16 durchgehenden Spalt 11 elektrisch voneinander getrennt sind. Der insbesondere in Fig. 3 ersichtliche Spalt 11 ist mit einem festen Isoliermaterial 12 wie Epoxydharz ausgefüllt, das die beiden Plattenelemente 10A, 10B mechanisch stabilisierend zusammenhält und mit ihnen die Trägerplatte 10 bildet.

Die Plattenelemente 10A, 10B könnten auch auf andere Weise als bei der dargestellten Ausführungsform zusammengehalten sein, beispielsweise durch eine entsprechend ausgebildete Isolierschicht zwischen den Plattenelementen und der Widerstandsbahn 15.

Zwischen der Widerstandsbahn 15 und der Trägerplatte 10 liegt bei der dargestellten Ausführungsform eine Isolierschicht 18, die ebenso wie die Enden der Widerstandbahn etwas gegen den seitlichen Rand der Plattenelemente 10A, 10B zurückgesetzt endet. Die dadurch freigelassenen Randbereiche der Plattenelemente sind von den Metallschichten 16 bedeckt, die sich entsprechend der Darstellung in Fig. 2 an den Enden der Widerstandsbahn 15 bis auf deren der Trägerlatte 10 abgewandte Oberfläche erstrecken. Dazwischen wird die Oberfläche des Widerstands darstellungsgemäß von der schon erwähnten Schutzlackschicht 20 bedeckt. Die Isolierschicht 18 besteht aus einer thermostabilen, möglichst gut wärmeleitenden Klebefolie, beispielsweise einer mit einem geeigneten Kleber bedeckten Folie aus Polyimid-Kunststoff.

Vorzugsweise bestehen die Plattenelemente 10A, 10B und zweckmäßig auch die Metallschichten 16 aus Kupfer, während die Widerstandsbahn aus einer der für Präzisionswiderstände bewährten CuNi- oder sonstigen Legierungen gebildet ist. Die nach außen frei liegenden Oberflächen der Kupferteile und insbesondere die großen, zum Auflöten des Widerstands auf eine Schaltungsplatte dienenden Anschlußflächen der Plattenelemente 10A,10B können zum Korrosionsschutz und zur Verbesserung der Lötbarkeit verzinnt sein.

Bei einer typischen Ausführungsform hat der dargestellte SMD-Widerstand eine Länge von etwa 7 mm und eine Gesamtdicke von etwa 0,8 mm.

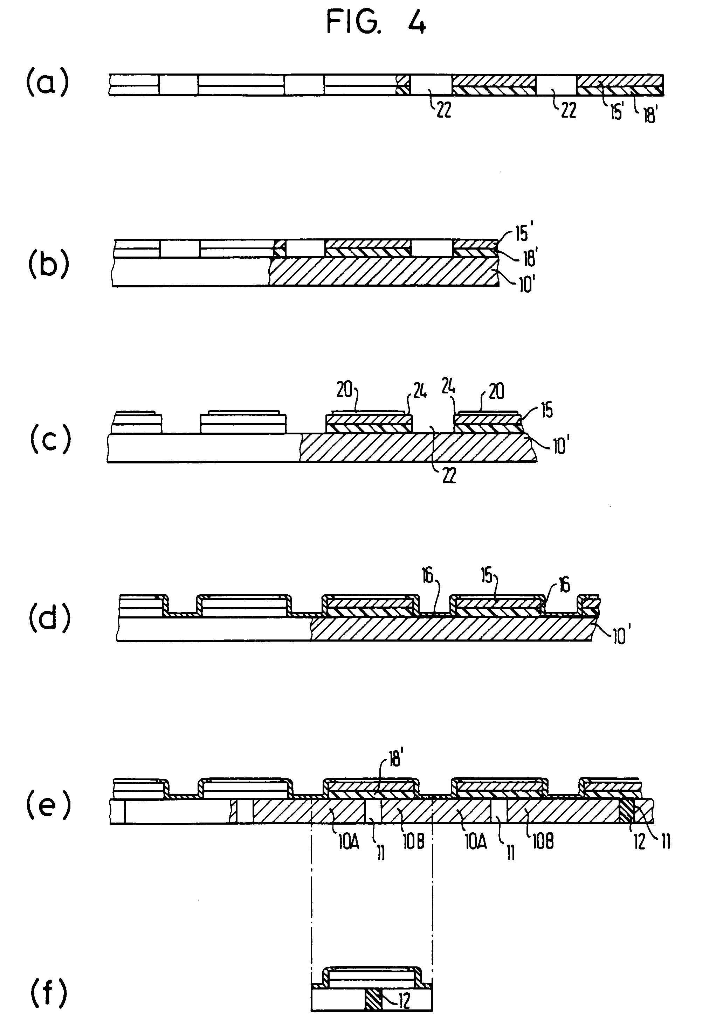

Die Herstellung des beschriebenen Widerstands kann erfindungsgemäß in den in Fig. 4 schematisch dargestellten Schritten erfolgen.

Zunächst wird gemaß Fig. 4 (a) aus einer dünnen metallischen Widerstandsfolie 15' und einer die Isolierschicht 18 (Fig. 2) bildenden dünnen Klebefolie 18' eine Verbundfolie in einer der Anzahl der gewünschten Widerstände entsprechenden Größe hergestellt. Wie schon erwähnt wurde, können problemlos mehr als 2000 Widerstände gemeinsam hergestellt werden. In dieser großflächigen Verbundfolie werden zueinander parallele Reihen von Langlöchern 22 erzeugt, deren Lage den später zu erzeugenden streifenförmigen Metallschichten 16 (Fig. 1) entspricht. Die Langlöcher 22 können mit einem Bohrautomaten erzeugt oder auch ausgestanzt werden. Bei der derzeit bevorzugten Methode enthält jede Reihe eine Vielzahl von in ihrer Längsrichtung beabstandeten Langlöchern 22, deren Länge nur etwas größer ist als die Breite der zu erzeugenden Bauelemente.

Die vorgebohrte dünne Verbundfolie wird gemäß Fig. 4 (b) auf ein dickeres, beispielsweise etwa 0,7 mm starkes Kupferblech 10' entsprechender Größe auflaminiert, das später die Trägerplatte 10 (Fig. 2) bilden soll. Die mechanische Zusammenfügung dieses Laminats kann in an sich bekannter Weise in einer Multilayer-Vakuumpresse erfolgen.

Anschließend wird gemäß Fig. 4 (c) in nicht dargestellter Weise die Widerstandsfolie 15' fotolithographisch strukturiert und geätzt, so daß die Widerstandsbahnen 15 der einzelnen Widerstände entstehen. Diese Widerstandsbahnen werden dann auf ihrer gemeinsamen Unterlage (also am sogenannten Nutzen) in an sich bekannter Weise durch mechanisches Fräsen mit einem rechnergesteuerten Mikrofräser abgeglichen. Nach erfolgtem Abgleich wird die geätzte Struktur im Siebdruckverfahren durch die Schutzlackschicht 20 beispielsweise aus Epoxydharz abgedeckt, wobei die an den Langlöchern 22 liegenden Randbereiche 24 der Oberfläche der Widerstandsbahnen 15 und die unter den Langlöchern 22 liegenden Bereiche des Kupferbleches 10' frei bleiben.

Der nächste Verfahrensschritt ist gemäß Fig. 4 (d) eine galvanische Verkupferung der nicht vom Schutzlack abgedeckten Bereiche zur Erzeugung der Metallschichten 16 (Fig. 1 und 2), die das Kupferblech 10' mit den Widerstandsbahnen 15 elektrisch verbinden. Die Schichtdicke der Metallschichten 16 kann etwa 30 bis 50 µm betragen.

Gemäß Fig. 4 (e) werden in das Kupferblech 10' jeweils in der Mitte unterhalb der Widerstandsbahnen zwischen je zwei Metallschichten 16 die Spalte 11 (Fig. 2 und 3) zur elektrischen Trennung der beiden mit je einer Metallschicht 16 verbundenen Plattenelemente 10A,10B der jeweiligen Widerstände erzeugt. Dies erfolgt vorzugsweise durch Ätzen des Kupferbleches 10' auf der Rückseite des Laminats. Anschließend, noch vor der Zerteilung des Laminats in die einzelnen Widerstände, werden die Spalte 11 mit Epoxydharz oder einem ähnlich geeigneten Isoliermaterial 12 (Fig. 2) ausgefüllt, was auf eine der Siebdrucktechnik entsprechende Weise erfolgen kann.

Erst nach Vollendung aller oben beschriebenen Verfahrensschritte sollen bei dem hier betrachteten Beispiel gemäß Fig. 4 (f) die Widerstände vereinzelt werden. Eine Möglichkeit hierfür ist die Verwendung einer Koordinatenstanze, die die Widerstände nacheinander längs Schnittlinien abtrennt, die mittig längs der Langlöcher 22 durch die Metallschichten 16 bzw. senkrecht hierzu längs der Ränder der Widerstandsbahnen verlaufen, so daß sich die Bauelemente der in Fig. 1 und Fig. 3 erkennbaren Form ergeben.

Die vereinzelten Widerstände können abschließend gemeinsam allseitig galvanisch verzinnt werden, beispielsweise in einem metallischen Korb, und bedürfen dann nur noch einer Reinigung und der elektrischen Prüfung in einer automatischen Prüfvorrichtung.

Im Rahmen der Erfindung sind Abweichungen von dem beschriebenen Verfahrensablauf möglich. Insbesondere ist es denkbar, die zeitliche Reihenfolge einzelner Verfahrensschritte einschließlich der anhand von Fig. 4 (a), (b) und (c) erläuterten Schritte zu ändern.

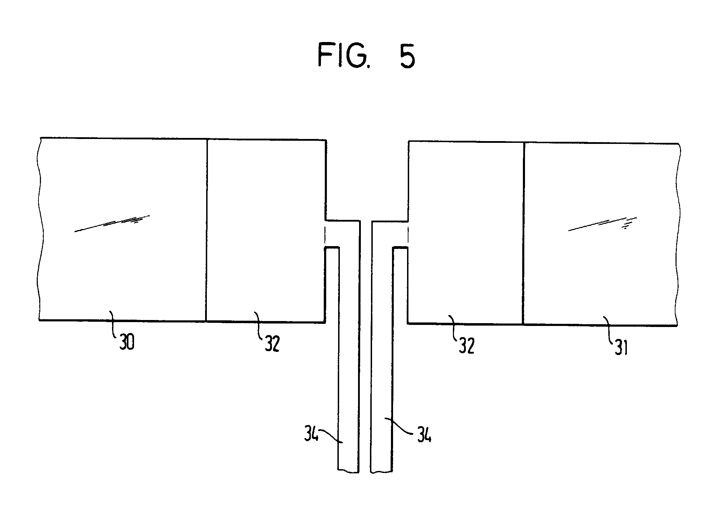

Zur Erläuterung eines Verwendungsbeispiels für Widerstände der hier beschriebenen Art sind in Fig. 5 zwei elektrisch voneinander getrennte Stromanschlußleiter 30, 31 einer Leiterplatte dargestellt, die jeweils in einem verzinnten Anschlußfleck 32 enden. Die geometrische Lage der voneinander getrennten Anschlußflecke 32 entspricht etwa der Form und Größe der Anschlußflächen 19 an der Unterseite der Widerstände, die auf diese Anschlußflecke 32 aufgelötet werden sollen.

Wie schon erwähnt wurde, bedürfen in der Regel die Widerstände der hier beschriebenen Art selbst keiner Vierleiterausführung. Die an sich üblichen Spannungsmeßanschlüsse können stattdessen in Form der zusätzlichen Leiter 34 auf der Leiterplatte an die Anschlußflecke 32 angeschlossen sein, zweckmäßig in der dargestellten geometrischen Anordnung, bei der sie in dem Spalt zwischen den Anschlußflecken 32 jeweils an deren Mitte angeschlossen und durch den genannten Spalt senkrecht zum Verlauf der Stromanschlußleiter 30,31 herausgeführt sind.

## Patentansprüche

1. Widerstand in SMD-Bauweise mit einer mindestens eine Widerstandsbahn (15) bildenden Widerstandsschicht, insbesondere einer Folie aus einer Widerstandslegierung, und mit mindestens zwei voneinander elektrisch isolierten, mit der Widerstandsbahn (15) elektrisch leitend verbundenen metallischen Kontaktelementen, die in einer Ebene wenigstens annähernd parallel zu der Widerstandsbahn (15) liegende Anschlußflächen (19) haben, mit denen der Widerstand flach auf Anschlußleiter einer Leiterplatte auflötbar ist, **dadurch gekennzeichnet,** daß die Kontaktelemente als Trägerplattenelemente (10A,10B) aus wärmeleitendem Metall ausgebildet sind, auf deren zu den Anschlußflächen (19) entgegengesetzten Oberflächen die Widerstandsbahn (15) angeordnet ist.

2. Widerstand nach Anspruch 1, **dadurch gekennzeichnet,** daß sich zwischen den metallischen Trägerplattenelementen (10A,10B) und der Widerstandsbahn (15) eine Isolierschicht (18) befindet, an deren Rändern eine die Widerstandsbahn (15) mit den Trägerplattenelementen (10A,10B) verbindende Metallschicht (16) vorgesehen ist.

3. Widerstand nach Anspruch 1 oder 2, **dadurch gekennzeichnet,** daß die beiden Trägerplattenelemente (10A,10B) durch ein mechanisch stabiles Isoliermaterial fest miteinander verbunden sind, das einen zwischen den beiden Anschlußflächen (19) verlaufenden, die beiden Trägerplattenelemente (10A,10B) elektrisch voneinander isolierenden Spalt (11) ausfüllt.

4. Widerstand nach einem der vorangehenden Ansprüche, **dadurch gekennzeichnet,** daß die Trägerplattenelemente (10A,10B) aus Kupferblechstücken bestehen.

5. Widerstand nach einem der vorangehenden Ansprüche, **dadurch gekennzeichnet,** daß die Trägerplattenelemente (10A, 10B) mindestens an ihren Anschlußflächen verzinnt sind.

6. Widerstand nach einem der vorangehenden Ansprüche, **dadurch gekennzeichnet,** daß die Isolierschicht (18) aus einer gut wärmeleitenden Klebefolie besteht.

7. Verfahren zum Herstellen von Widerständen nach einem der vorangehenden Ansprüche, bei dem eine Folie (15') aus einer Widerstandslegierung auf einer Trägerplatte (10') aus wärmeleitendem Metall befestigt wird und bei dem durch selektives Entfernen von Teilen der Folie (15') Widerstandsbahnen (15) gebildet werden, **dadurch gekennzeichnet,** daß die Trägerplatte (10') elektrisch mit Teilen der Widerstandsfolie (15') verbunden und in einzelne, jeweils mit einem Ende einer Widerstandsbahn (15) elektrisch verbundene Kontaktelemente (10A, 10B) zertrennt wird.

8. Verfahren nach Anspruch 7, **gekennzeichnet durch** die folgenden Verfahrensschritte:
a) in einer aus einer Widerstandsfolie (15') und einer Klebefolie (18') bestehenden Verbundfolie wird ein Muster aus zueinander parallelen Langlöchern oder Reihen von Langlöchern (22) erzeugt;
b) die Verbundfolie wird auf ein Metallblech (10') laminiert;
c) die Widerstandsfolie (15') wird zur Erzeugung einer Vielzahl einzelner Widerstandsbahnen (15) fotolithographisch strukturiert und geätzt und danach durch eine Schutzschicht (20) abgedeckt, wobei Randbereiche (24) der Widerstandsbahnen und Oberflächenbereiche des Metallblechs (10') in den Langlöchern (22) freigelassen werden;
d) die von der Schutzschicht (20) freigelassenen Bereiche werden zur elektrischen Verbindung der Widerstandsbahnen (15) mit dem Metallblech (10') metallisiert;
e) jeweils mit den beiden Randbereichen (24) einer Widerstandsbahn (15) verbundene Teile des Metallblechs (10') werden durch Bildung eines bis zu der Klebefolie (18') durchgehenden, parallel zu den Langlöchern (22) verlaufenden Spalt (11) voneinander getrennt, wobei auf beiden Seiten des Spaltes (11) je ein Plattenelement (10A,10B) verbleibt;
f) das aus der Verbundfolie und dem Metallblech (10') gebildete Laminat wird längs der Langlöcher (22) unter Zerteilung der darin befindlichen Metallschichten (16) und quer hierzu längs der Ränder der Widerstandsbahnen (15) in die einzelnen Widerstände zerteilt.

9. Verfahren nach Anspruch 8**, dadurch gekennzeichnet,** daß die Spalte (11) des Metallblechs (10') mit einem mechanisch stabilisierenden Kunststoff ausgefüllt werden.

10. Verfahren nach Anspruch 8 oder 9, **dadurch gekennzeichnet,** daß die Spalte (11) des Metallblechs (10') durch Ätzen erzeugt werden.

11. Verfahren nach einem der Ansprüche 7 bis 10, **dadurch gekennzeichnet,** daß die elektrische Verbindung zwischen den Widerstandsbahnen (15) und den Kontaktelementen durch galvanische Metallisierung erfolgt.

12. Verfahren nach einem der Ansprüche 7 bis 11, **dadurch gekennzeichnet,** daß auf der Trägerplatte ein Muster aus einer Vielzahl von in zueinander senkrechten Spalten und Zeilen angeordneten Widerstandsbahnen erzeugt wird.

13. Verwendung eines Widerstands nach einem der vorangehenden Ansprüche auf einer Leiterplatte, die zwei den Anschlußflächen (19) der Trägerplattenelemente (10A,10B) entsprechend angeordnete Anschlußflächen (32) an Stromanschlußleitern (30,31) und zur Bildung von Vierleiteranschlüssen zwei zusätzliche, von den Anschlußflächen (32) der Leiterplatte wegführende Spannungsanschlußleiter (34) aufweist.

14. Verwendung nach Anspruch 13, **dadurch gekennzeichnet,** daß die Spannungsanschlußleiter (34) in dem Spalt zwischen den Anschlußflächen (32) der Leiterplatte an deren Mitte angeschlossen sind.

## Claims

1. Resistor of SMD construction with at least one resistive layer forming a resistive track (15), particularly a film of a resistive alloy, and with at least two metallic contact elements which are electrically conductively connected to the resistive track (15) and are electrically insulated from one another and which have connector surfaces (19) lying in a plane at least approximately parallel to the resistive track (15) with which the resistor may be soldered flat to terminals on a printed circuit board, characterised in that the contact elements are constructed as carrier plate elements (10A,10B) of thermally conductive metal on whose surfaces opposed to the connector surfaces (19) the resistive track (15) is arranged.

2. Resistor as claimed in claim 1, characterised in that disposed between the metallic carrier plate elements (10A,10B) and the resistive track (15) there is an insulating layer (18) at whose edges a metallic layer (16) is provided which connects the resistive track (15) to the carrier plate elements (10A,10B).

3. Resistor as claimed in claim 1 or 2, characterised in that the two carrier plate elements (10A,10B) are rigidly connected together by a mechanically stable insulating material which fills a gap (11) which extends between the two connecting surfaces (19) and electrically insulates the two carrier plate elements (10A,10B) from one another.

4. Resistor as claimed in one of the preceding claims, characterised in that the carrier plate elements (10A,10B) comprise pieces of copper plate.

5. Resistor as claimed in one of the preceding claims, characterised in that the carrier plate elements (10A,10B) are tin plated at least on their connector surfaces.

6. Resistor as claimed in one of the preceding claims, characterised in that the insulating layer (18) comprises a good thermally conductive adhesive film.

7. Method of manufacturing resistors as claimed in one of the preceding claims in which a film (15') of a resistive alloy is secured to a carrier plate (10') of thermally conductive metal and in which resistive tracks are formed by the selective removal of parts of the film (15'), characterised in that the carrier plate (10') is electrically connected to parts of the resistive film (15') and is split into individual contact elements (10A,10B), each of which is electrically connected to an end of a resistive track (15).

8. Method as claimed in claim 7, characterised by the following method steps:
(a) a pattern of elongate holes or rows of elongate holes (22) parallel to one another is produced in a composite film comprising a resistive film (15') and an adhesive film (18');
(b) the composite film is laminated onto a metallic plate (10');
(c) the resistive film (15') is photolithographically structured and etched to produce a plurality of individual resistive tracks (15) and thereafter covered by a protective layer (20), edge regions (24) of the resistive tracks and surface regions of the metal plate (10') in the elongate holes (22) being left free;
(d) the regions left free of the protective layer (20) are metallised to electrically connect the resistive tracks (15) to the metal plate (10');
(e) the parts of the metal plate (10') which are connected to the two edge regions (24) of a resistive track (15) are separated from one another by forming a continuous gap (11) extending parallel to the elongate holes (22) to the adhesive film (18'), a respective plate element (10A,10B) remaining on the two sides of the gap (11) ;
(f) the laminate constituted by the composite film and the metal plate (10') is split into the individual resistors along the length of the elongate holes (22) whilst splitting the metallic layers (16) situated therein and transversely thereto along the length of the edges of the resistive tracks (15).

9. Method as claimed in Claim 8, characterised in that the gaps (11) in the metal plate (10') are filled with a mechanically stabilising plastics material.

10. Method as claimed in Claim 8 or 9, characterised in that the gaps (11) in the metal plate (10') are produced by etching.

11. Method as claimed in one of Claims 7 to 10, characterised in that the electrical connection between the resistive tracks (15) and the contact elements is effected by galvanic metallizing.

12. Method as claimed in one of Claims 7 to 11, characterised in that a pattern comprising a plurality of resistive tracks arranged in columns and lines perpendicular to one another is produced on the carrier plate.

13. Use of a resistor as claimed in one of the preceding claims on a printed circuit board which has two connecting surfaces (32) on conductive terminals (30, 31) arranged in a manner corresponding to the connector surfaces (19) on the carrier plate elements (10A, 10B) and two additional voltage connector leads (34) leading away from the connector surfaces (32) of the printed circuit board to form four-pole terminations.

14. Use as claimed in Claim 13, characterised in that the voltage connector leads (34) are connected in the gap between the connector surfaces (32) of the printed circuit board to the centre thereof.

## Revendications

1. Résistance électrique sous forme de puce, comprenant au moins une couche résistante, constituant une piste résistante (15), en particulier comportant une feuille constituée d'un alliage présentant une résistance électrique, et avec au moins deux éléments de contact métalliques isolés électriquement l'un de l'autre, reliés de façon à conduire l'électricité, à la piste conductrice (15) et ayant dans un plan des surfaces de raccordement (19) au moins à peu près parallèles à la piste résistante (15) et à l'aide desquelles la résistance électrique peut être montée à plat par brasage sur le conducteur de raccordement d'une plaquette à circuit imprimé, caractérisée en ce que les éléments de contact sont réalisés sous forme d'éléments formant plaque-support (10A, 10B), constitués d'un métal présentant une conductibilité thermique et sur les surfaces, opposées aux surfaces de raccordement (19) desquelles est disposée la piste conductrice.

2. Résistance électrique selon la revendication 1, caractérisée en ce qu'entre les éléments formant plaque-support (10A, 10B) métalliques et la piste résistante (15) se trouve une couche isolante (18), sur les bords de laquelle est prévue une couche métallique (16) reliant la piste résistante (15) aux éléments formant plaque-support (10A, 10B).

3. Résistance électrique selon la revendication 1 ou 2, caractérisée en ce que les deux éléments formant plaque-support (10A, 10B) sont reliés rigidement ensemble au moyen d'un matériau isolant mécaniquement stable qui comble l'interstice (11) s'étendant entre les deux surfaces de raccordement (19) et qui isole électriquement l'un de l'autre les deux éléments formant plaque-support (10A, 10B).

4. Résistance électrique selon l'une des revendications précédentes, caractérisée en ce que les éléments formant plaque-support (10A, 10B) sont constitués de morceaux de tôle de cuivre.

5. Résistance selon l'une revendications précédentes, caractérisée en ce que les éléments formant plaque-support (10A, 10B) sont étamés au moins sur leurs surfaces de raccordement.

6. Résistance électrique selon l'une des revendications précédentes, caractérisée en ce que la couche isolante (18) est constituée d'une feuille adhésive bonne conductrice de la chaleur.

7. Procédé de fabrication de résistances électriques selon l'une des revendications précédentes, dans lequel une feuille (15') constituée d'un alliage résistant est fixée sur une plaque-support (10') en métal conducteur de la chaleur et pour lequel des pistes résistantes (15) sont constituées par enlèvement sélectif de parties de la feuille (15'), caractérisé en ce que la plaque-support (10') est reliée électriquement à des parties de la feuille résistante (15') et est détruite avec effet de séparation en donnant des éléments de contact (10A, 10B) individuels reliés électriquement chaque fois à une extrémité d'une piste conductrice (15).

8. Procédé selon la revendication 7, caractérisé par les étapes de procédé ci-après :
a) dans une feuille composite constituée d'une feuille résistante (15') et d'une feuille adhésive (18') est produit un motif constitué de trous oblongs parallèles entre eux ou de rangées de trous oblongs (22);
b) la feuille composite est laminée sur une tôle métallique (10');
c) la feuille résistante (15') est structurée par voie photolithographique pour produire une pluralité de pistes résistantes (15) individuelles et est soumise à une morsure chimique puis est recouverte par une couche protectrice (20), les zones marginales (24) des pistes résistantes et des zones de surface de la tôle métallique (10') étant laissées dégagées dans les trous oblongs (22);
d) les zones laissées libres par la couche protectrice (20) sont métallisées pour assurer une liaison électrique entre les pistes résistantes (15) et la tôle métallique (10');
e) les parties de la tôle métallique (10') qui sont respectivement reliées aux deux zones marginales (24) d'une piste résistante (15) sont séparées l'une de l'autre par formation d'un interstice (11) ininterrompu jusqu'à la feuille adhésive (18') et courant parallèlement au trou oblong (22), un élément formant plaque (10A, 10B) subsistant sur chacun des deux côtés de l'interstice (11) ;
f) le laminé constitué de la feuille composite et de la tôle métallique (10') est divisé en suivant la direction longitudinale des trous oblongs (22), avec fragmentation des couches métalliques (16) s'y trouvant et, dans la direction transversale à celle-ci, en suivant la longueur des bordures des pistes résistantes (15), en donnant les différentes résistances électriques.

9. Procédé selon la revendication 8, caractérisé en que les interstices (11) de la tôle métallique (10') sont comblés d'une matière synthétique ayant un effet mécaniquement stabilisateur.

10. Procédé selon la revendication 8 ou 9, caractérisé en ce que les interstices (11) de la tôle métallique (10') sont produits par morsure chimique.

11. Procédé selon l'une des revendications 7 à 10, caractérisé en ce que la liaison électrique constituée entre les pistes conductrices (11) et les éléments de contact s'effectue par métallisation galvanique.

12. Procédé selon l'une des revendications 7 à 11, caractérisé en ce qu'un motif constitué d'une pluralité de pistes résistantes disposées en colonnes perpendiculaires entre elles et en lignes est produit sur la plaque formant support.

13. Utilisation d'une résistance électrique selon l'une des revendications précédentes sur une plaquette de circuit imprimé, qui présente sur des conducteurs de raccordement électrique (30, 31) deux surfaces de raccordement (32) disposées de manière correspondante entre les surfaces de raccordement (19) des éléments formant plaque-support (10A,10B) et deux conducteurs de raccordement de tension (34) supplémentaires, partant des surfaces de raccordement (32) de la plaquette à circuit imprimé, pour constituer des raccordements à quatre conducteurs.

14. Utilisation selon la revendication 13, caractérisée en ce que les conducteurs de raccordement de tension (34) se trouvant dans l'interstice existant entre les surfaces de raccordement (32) de la plaquette à circuit imprimé sont raccordés en leur centre.
